# EUROPEAN PATENT SPECIFICATION

(11) **EP 2 782 146 B1**
(45) Date of publication and mention of the grant of the patent: **12.10.2016**
(21) Application number: 13174068.0
(22) Date of filing: 27.06.2013
(51) Int. Cl.: H01L 31/18, H01L 31/0216

(54) **Method for manufacturing a solar cell with reduced potential induced degradation**
Herstellungsverfahren einer Solarzelle mit reduzierter durch Antipotenzial induzierter Verschlechterung
Procédé de fabrication d'une cellule solaire présentant une dégradation induite par potentiel réduite

(30) Priority: 21.03.2013 CN 201310092404
(43) Date of publication of application: 24.09.2014
(73) Proprietor: Jinkosolar Holding Co., Ltd., 334100 Jiangxi (CN)
(72) Inventor: Huang, Jide, 334100 Jiangxi (CN); Jiang, Fangdan, 334100 Jiangxi (CN); Jin, Hao, 334100 Jiangxi (CN); Chen, Kangping, 334100 Jiangxi (CN)
(74) Representative: Epping - Hermann - Fischer

(56) References cited:
- US-A1- 2010 029 038
- US-A1- 2011 000 531
- US-A1- 2011 162 706
- HOFMANN M. ET AL.: "Firing stable surface passivation using all-PECVD stacks of SiOx:H and SiNx:H", THE COMPILED STATE-OF-THE-ART OF PV SOLAR TECHNOLOGY AND DEPLOYMENT : 22ND EUROPEAN PHOTOVOLTAIC SOLAR ENERGY CONFERENCE, EU PVSEC ; PROCEEDINGS OF THE INTERNATIONAL CONFERENCE, HELD IN MILAN, ITALY, 3 - 7 SEPTEMBER 2007, MUNICH : WIP-RENEWABLE ENERG, 3 September 2007 (2007-09-03), pages 1030-1033, XP040513304, ISBN: 978-3-936338-22-5

## Description

### FIELD OF THE INVENTION

The present invention relates to the technical field of solar cell manufacturing, and in particular to a solar cell of anti potential induced degradation and a manufacturing method thereof

### BACKGROUND OF THE INVENTION

Solar energy is clean energy. The photovoltaic module is an apparatus for converting light energy into electrical energy by utilizing photovoltaic effect of the PN junction of silicon material. The photovoltaic module includes: a glass backboard and a glass substrate which are arranged oppositely; a solar cell arranged between the glass backboard and the glass substrate; a packaging frame for fixing the glass backboard, the solar cell and the glass substrate; and so on.

The conventional processes for manufacturing the solar cell include processes such as texturing, diffusion, etching, chemical vapor deposition (i.e., PECVD), screen printing and sintering. In the texturing process, the surface of the silicon wafer is eroded by using acid or alkali to form different surface patterns, i.e., surface texturization, therefore the light reflectance is reduced, the short-circuit current is increased and the photoelectric conversion efficiency of the solar cell is ultimately improved. In the diffusion process, the impurity diffusion is performed on the silicon wafer to form a PN junction, which acts as a "heart" of the semiconductor device when the semiconductor device operates. In the etching process, the P-type region and N-type region of the silicon wafer are separated from each other. In the PECVD process, the gas containing the atom which composes the film is ionized by using microwave or radio frequency, to form plasma which has strong chemical activity and is prone to chemical reaction, so that a desired anti-reflection film is deposited on the surface of the silicon wafer. In the screen printing process, by using the adhesive tape on the printing blade, slurry is moved through a screen template with an image or a pattern, to print on the surface of the silicon wafer and form a printed electrode. In the sintering process, the organic component in the slurry is burnt out, so that a good ohmic contact is formed between the slurry and the silicon wafer.

However, in the photovoltaic module manufactured by using the existing solar cell manufacturing processes, a potential induced degradation (referred to as PID for short) effect is prone to occur. That is, the photovoltaic module operates under a high negative voltage for a long time, so there will be a leakage current passage between the glass substrate and the package material. Therefore, a large number of charges are accumulated on the surface of the solar cell, and the charges accumulated on the surface of the solar cell may draw photogenic charge carriers, leading to leakage current. Therefore, electrical performance parameters of the photovoltaic module, such as the fill factor FF, the short circuit current Jsc and the open circuit voltage Voc are deteriorated, and thus the electrical performance of the photovoltaic module will be lower than the design criteria.

US 2010/029038 A1 describes a solar cell manufacturing method comprising the step of forming a passivation film on a surface layer of a silicon layer by performing an oxidation process, a nitridation process or an oxynitriding process on the surface layer of the silicon layer by using plasma.

Document XP040513304 describes a SiOx/SiNx/SiOx stack system for passivating the rear sides of silicon solar cells.

### SUMMARY OF THE INVENTION

In order to solve the above-mentioned technical problem, a solar cell of anti potential induced degradation and a manufacturing method thereof are provided according to embodiments of the invention. The solar cell manufactured by using the manufacturing method has a good electrical insulation property with outside packaging material and the glass substrate, so the corresponding photovoltaic module has an anti potential induced degradation effect, which improves the electrical performance of the photovoltaic module operating under the high negative voltage for a long time.

In order to solve the above-mentioned problem, following technical solutions are provided according to embodiments of the invention.

A method for manufacturing a solar cell of reduced potential induced degradation includes: performing plasma cleaning on a silicon wafer by using an oxidizing gas, so as to form a first silicon oxide film on the surface of the silicon wafer; and forming an anti-reflection film on the surface of the first silicon oxide film, where the anti-reflection film includes at least a silicon oxide film; wherein the forming an anti-reflection film on the surface of the first silicon oxide film comprises: depositing a uniform silicon nitride film on the surface of the first silicon oxide film, and depositing a uniform silicon oxide film on the surface of the silicon nitride film, so as to form the anti-reflection film.

Preferably, the oxidizing gas includes at least N₂O.

Preferably, the plasma cleaning lasts for 30s to 900s, inclusive.

Preferably, the silicon oxide film in the anti-reflection film is deposited by using a method of PECVD, APCVD or LPCVD.

Preferably, the silicon oxide film in the anti-reflection film is formed by gas including N₂O and SiH₄, and gas flow ratio of N₂O to SiH₄ ranges from 1 to 50:1, inclusive.

Preferably, the silicon oxide film in the anti-reflection film has a thickness that ranges from 1nm to 150nm, inclusive.

Preferably, the silicon nitride film in the anti-reflection film is deposited by using a method of PECVD, APCVD or LPCVD.

Preferably, the silicon nitride film in the anti-reflection film is formed by gas including NH₃ and SiH₄, and gas flow ratio of NH₃ to SiH₄ ranges from 1 to 30:1, inclusive.

Preferably, the silicon nitride film in the anti-reflection film has a thickness that ranges from 10nm to 150nm, inclusive.

Compared with the prior art, the above-mentioned technical solutions have the following advantages.

According to the technical solutions provided by the embodiments of the invention, the plasma cleaning is firstly performed on the silicon wafer by using the oxidizing gas, so as to form a compact first silicon oxide film on the surface of the silicon wafer while cleaning the silicon wafer; then the anti-reflection film is formed on the surface of the cleaned silicon wafer, i.e., the anti-reflection film is formed on the surface of the first silicon oxide film, where the anti-reflection film includes at least a silicon oxide film. Since the silicon oxide film has a good electrical insulation property and an anti-reflection effect, the solar cell manufactured by using the manufacturing method provided by the embodiments of the invention has a good electrical insulation property with the packaging material and the glass substrate, so the corresponding photovoltaic module has an anti potential induced degradation effect, which improves the electrical performance of the photovoltaic module operating under the high negative voltage for a long time.

### BRIEF DESCRIPTION OF THE DRAWINGS

The accompanying drawings needed to be used in the description of the embodiments or the prior art will be described briefly as follows, so that the technical solutions according to the embodiments of the present invention or according to the prior art will become clearer. It is obvious that the accompanying drawings in the following description are only some embodiments of the present invention. For those skilled in the art, other accompanying drawings may be obtained according to these accompanying drawings without any creative work.
Figure 1 is a schematic flowchart of a method for manufacturing a solar cell according to an embodiment of the invention; and
Figures 2, 3 and 6 are sectional views of the solar cell during the manufacturing method according to embodiments of the invention.
Figures 4, 5 and 7 are sectional views of the solar cell during the manufacturing method according to examples not being part of the present invention.

### DETAILED DESCRIPTION OF THE INVENTION

As described in the background, in the photovoltaic module manufactured by using the existing solar cell manufacturing processes, the potential induced degradation effect is prone to occur, so the electrical performance parameters of the photovoltaic module, such as FF, Jsc and Voc are deteriorated and will be lower than the design criteria when the photovoltaic module operates under the high negative voltage for a long time.

The inventor has found that there are mainly two reasons which cause the potential induced degradation effect, one is related to the photovoltaic module system and the other is related to the photovoltaic module.

As for the photovoltaic module system, it is indicated by the research and the actual operation of the power plant that, in a case that all of the photovoltaic modules between the solar cell module in the middle of the solar cell module array and the negative output terminal of the inverter operate under negative bias, the closer the solar cell module is to the negative output terminal of the inverter, the stronger the potential induced degradation effect is; and in a case that all of the modules between the solar cell module in the middle of the solar cell module array and the positive output terminal of the inverter operate under positive bias, the potential induced degradation effect is not obvious. Whether the solar cell module and the solar cell thereof operate under the positive bias or the negative bias is depended on the grounding mode of the photovoltaic module system and the position of the photovoltaic module in the solar cell module array.

As for the photovoltaic module, external environmental conditions, such as temperature and humidity, may cause leakage current passages to be formed among the packaging material, the glass backboard, the glass substrate and the packaging frame of the photovoltaic module, and thus the leakage current is formed between the solar cell and the grounding frame. Therefore, the electrical performance parameters of the photovoltaic module, such as the fill factor FF, the short-circuit current Jsc and the open circuit voltage Voc are deteriorated, and thus the electrical performance of the photovoltaic module will be lower than the design criteria.

The inventor has also found that the method for reducing the potential induced degradation effect of the photovoltaic module in the prior art is mainly to use packaging material with high body resistance and good quality. Although this method can reduced the potential induced degradation effect to some extent, the cost of the photovoltaic module is greatly increased.

Based on the above-mentioned researches, a method for manufacturing a solar cell of anti potential induced degradation is provided according to the embodiments of the invention. The method for manufacturing the solar cell includes: performing plasma cleaning on a silicon wafer by using an oxidizing gas, so as to form a first silicon oxide film on the surface of the silicon wafer; and
forming an anti-reflection film on the surface of the first silicon oxide film, where the anti-reflection film includes at least a silicon oxide film.

In the technical solution provided by the embodiments of the invention, the good electrical insulation property of the silicon oxide film is utilized. The plasma cleaning is firstly performed on the silicon wafer by using the oxidizing gas, so as to form a compact first silicon oxide film on the surface of the silicon wafer while cleaning the silicon wafer. Then, the anti-reflection film is formed on the surface of the cleaned silicon wafer, i.e., the anti-reflection film is formed on the surface of the first silicon oxide film, where the anti-reflection film includes at least a silicon oxide film. Therefore, the solar cell manufactured by using the manufacturing method according to the embodiments of the invention has a good electrical insulation property with the outside structures such as the packaging material and the glass substrate, so the corresponding photovoltaic module has an anti potential induced degradation effect, which improves the electrical performance of the photovoltaic module operating under the high negative voltage for a long time. Moreover, there is no need for a special packaging material, leading to a low cost. Furthermore, the technical solution is also compatible with the conventional manufacturing processes of the solar cell and thus suitable for large-scale production.

To make the above objects, features and advantages of the invention more obvious and easy to be understood, specific embodiments of the invention will be illustrated in detail below in conjunction with the drawings.

More specific details will be set forth in the following descriptions for sufficient understanding of the invention. However, the invention may also be implemented in other ways different from the way described herein, and similar extensions may be made by those skilled in the art without departing from the scope of the invention as defined in the appended claims. Therefore, the invention is not limited to the specific implementations disclosed hereinafter.

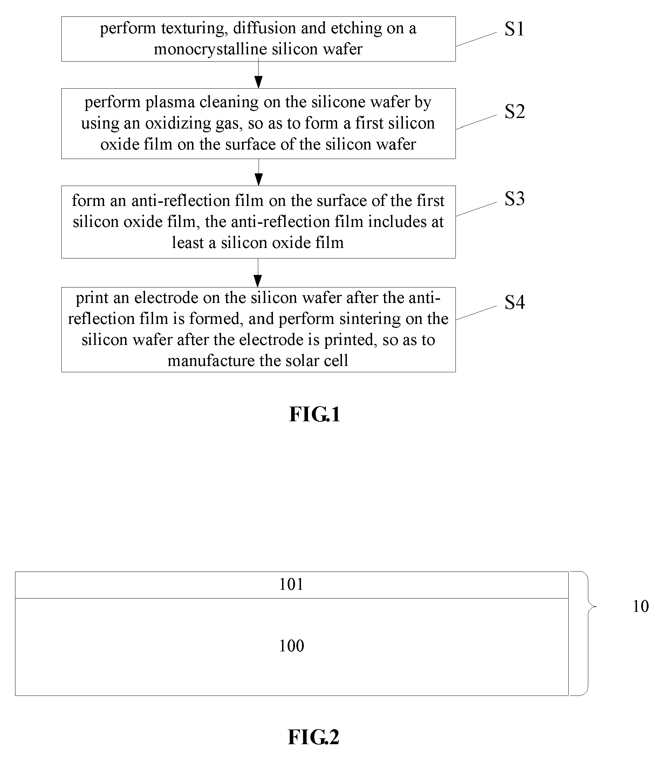

As shown in Figure 1, a method for manufacturing a solar cell is provided by an embodiment of the invention, including the following steps.

Step S1: performing texturing, diffusion and etching on a monocrystalline silicon wafer. It should be noted that the monocrystalline silicon wafer may be a P-type monocrystalline silicon wafer or an N-type monocrystalline silicon wafer, and it is not limited in the present invention. In the embodiment of the invention, the method for manufacturing the solar cell provided by the invention is described in detail by using the P-type monocrystalline silicon wafer as the monocrystalline silicon wafer as an example. Thus, in an embodiment of the invention, the performing texturing, diffusion and etching on a monocrystalline silicon wafer includes performing acid texturing, phosphorus diffusion and etching on a P-type monocrystalline silicon wafer.

Step S2: performing plasma cleaning on the silicon wafer by using an oxidizing gas, so as to form a first oxide layer film on the surface of the silicon wafer.

After the monocrystalline silicon wafer 100 is etched, the monocrystalline silicon wafer 100 is cleaned by using an oxidizing gas, so as to form a compact first silicon oxide film 101 on the surface of the monocrystalline silicon wafer 100 while removing the impurity on the surface of the monocrystalline silicon wafer 100, as shown in Figure 2. It should be noted that, in an embodiment of the invention, the oxidizing gas preferably includes at least N₂O, that is, the oxidizing gas is preferably N₂O or combination gas of NH₃ and N₂O. However, the invention is not limited thereto, as long as the impurity on the surface of the monocrystalline silicon wafer 100 can be removed and the compact first silicon oxide film 101 can be formed on the monocrystalline silicon wafer 100 during the cleaning. Preferably, the plasma cleaning lasts for 30s to 900s, inclusive.

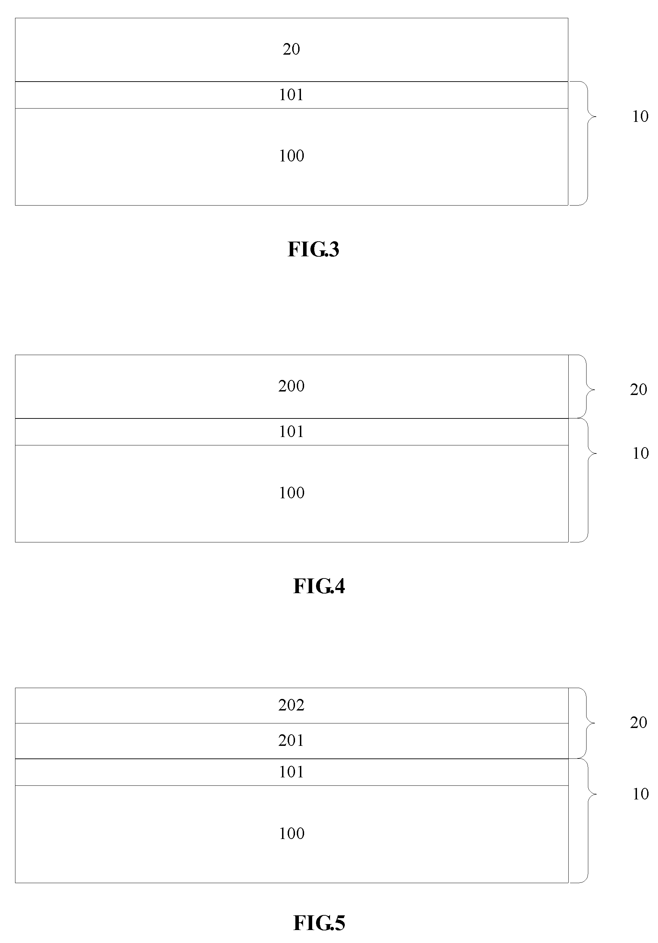

Step S3: placing the cleaned monocrystalline silicon wafer 10 into a coating apparatus, introducing a reaction gas into the coating apparatus, and forming an anti-reflection film 20 on the surface of the first silicon oxide film 101, where the anti-reflection film includes at least a silicon oxide film, as shown in Figure 3.

In the embodiment of the invention, the anti-reflection film 20 may be deposited by using a method of PECVD, APCVD or LPCVD, and the invention is not limited thereto. A commonly-used method for coating the anti-reflection film is PECVD, which mainly includes the following steps. The gas for forming the film is introduced into the coating apparatus. The gas for forming the film is ionized into ions under the action of a RF power supply and a large number of reactive groups are generated after multiple collisions. These reactive groups are absorbed onto the surface of the silicon wafer. The absorbed atoms migrate on the surface of the silicon wafer under the action of their owe kinetic energy and the temperature of the surface of the silicon wafer, and stabilize at the lowest energy point. Meanwhile, the atoms of the surface of the silicon wafer continuously get rid of the binding of the surrounding atoms and enter into the plasmas, to achieve dynamic balance. When the atom deposition speed is faster than the atom escape speed, the desired anti-reflection film can be continuously deposited on the surface of the silicon wafer.

Preferably, in the deposition of the anti-reflection film, the silicon oxide film may be deposited by using a method of PECVD, APCVD or LPCVD. The gas for forming the silicon oxide film includes N₂O and SiH₄, and the gas flow ratio of N₂O to SiH₄ ranges from 1 to 50:1, inclusive. It should be noted that, in the deposition of the anti-reflection film, the gas for forming the silicon oxide film may further include NH₃, and the gas flow ratio is not limited in the invention and may be determined according a specific process requirement. More preferably, the silicon oxide film has a thickness that ranges from 1nm to 150nm, inclusive.

It should be noted that the anti-reflection film 20 is a multi-film structure including a silicon oxide film and a silicon nitride film, so as to improve the light absorption rate of the anti-reflection film and thus improve the photoelectric conversion efficiency of the manufactured solar cell.

Preferably, in the deposition of the anti-reflection film, the silicon nitride film may be deposited by using a method of PECVD, APCVD or LPCVD. The gas for forming the silicon nitride film includes NH₃ and SiH₄, and the gas flow ratio of NH₃ to SiH₄ ranges from 1 to 30:1, inclusive. More preferably, the silicon nitride film has a thickness that ranges from 10nm to 150nm, inclusive.

In an example not being part of the present invention, the forming an anti-reflection film 20 on the surface of the first silicon oxide film 101 includes: introducing the gas for forming the silicon oxide film into the coating apparatus, and depositing a uniform silicon oxide film 200 on the surface of the first silicon oxide film 101, so as to form the anti-reflection film 20, as shown in Figure 4. In a specific example of the embodiment, the gas for forming the silicon oxide film 200 in the anti-reflection film 20 includes N₂O and SiH₄, where the gas flow rate of N₂O is 2000sccm, and the gas flow rate of SiH₄ is 200sccm. More preferably, the deposited silicon oxide film 200 has a thickness of 70nm and a refractive index of 1.5.

In another example not being part of the present invention, the forming an anti-reflection film 20 on the surface of the first silicon oxide film 101 includes: introducing the gas for forming the silicon oxide film into the coating apparatus, and depositing a uniform silicon oxide film 201 on the surface of the first silicon oxide film 101; and then introducing the gas for forming the silicon nitride film into the coating apparatus, and depositing a uniform silicon nitride film 202 on the surface of the silicon oxide film 201, so as to form the anti-reflection film 20, as shown in Figure 5.

In a specific implementation of said example, the gas for forming the silicon oxide film 201 in the anti-reflection film 20 includes N₂O and SiH₄, where the gas flow rate of N₂O is 2000sccm, and the gas flow rate of SiH₄ is 200sccm. More preferably, the deposited silicon oxide film 201 has a thickness of 10nm and a refractive index of 1.5. Moreover, the gas for forming the silicon nitride film 202 in the anti-reflection film 20 includes NH₃ and SiH₄, where the gas flow rate of NH₃ is 6000sccm, and the gas flow rate of SiH₄ is 560sccm. More preferably, the deposited silicon nitride film 202 has a thickness of 70nm and a refractive index of 2.06.

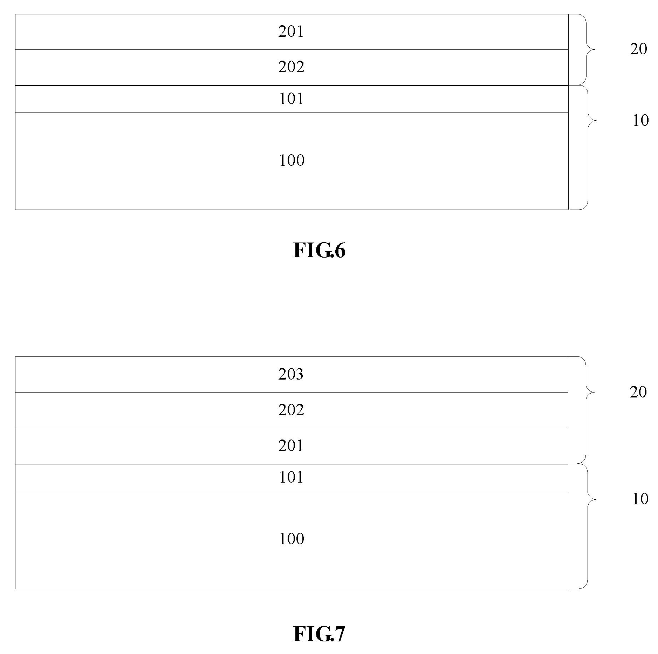

In the embodiment of the present invention, the forming an anti-reflection film 20 on the surface of the first silicon oxide film 101 includes: introducing the gas for forming the silicon nitride film into the coating apparatus, and depositing a uniform silicon nitride film 202 on the surface of the first silicon oxide film 101; then introducing the gas for forming the silicon oxide film into the coating apparatus, and depositing a uniform silicon oxide film 201 on the surface of the silicon nitride film 202, so as to form the anti-reflection film 20, as shown in Figure 6.

In a specific implementation of the embodiment, the gas for forming the silicon nitride film 202 in the anti-reflection film includes NH₃ and SiH₄, where the gas flow rate of NH₃ is 6000sccm, and the gas flow rate of SiH₄ is 600sccm. More preferably, the deposited silicon nitride film 202 has a thickness of 70 nm and a refractive index of 2.07. Moreover, the gas for forming the silicon oxide film 201 in the anti-reflection film includes N₂O and SiH₄, where the gas flow rate of N₂O is 2000sccm, and the gas flow rate of SiH₄ is 200sccm. More preferably, the deposited silicon oxide film 201 has a thickness of 10nm and a refractive index of 1.5.

In still another example not being part of the present invention, the forming an anti-reflection film 20 on the surface of the first silicon oxide film 101 includes: introducing the gas for forming the silicon oxide film into the coating apparatus, and depositing a uniform silicon oxide film 201 on the surface of the first silicon oxide film 101; then introducing the gas for forming the silicon nitride film into the coating apparatus, and depositing a uniform silicon nitride film 202 on the surface of the silicon oxide film 201; and then introducing again the gas for forming the silicon oxide film into the coating apparatus, and depositing a uniform silicon oxide film 203 on the surface of the silicon nitride film 202, so as to form the anti-reflection film 20, as shown in Figure 7.

In a specific implementation of said example, the gas for forming the silicon oxide film 201 located on the side of the silicon nitride film 202 near the silicon wafer 10 includes N₂O and SiH₄, where the gas flow rate of N₂O is 2000sccm, and the gas flow rate of SiH₄ is 200sccm. More preferably, the deposited silicon oxide film 201 has a thickness of 5nm and a refractive index of 1.5. Moreover, the gas for forming the silicon nitride film 202 includes NH₃ and SiH₄, where the gas flow rate of NH₃ is 6000sccm, and the gas flow rate of SiH₄ is 560sccm. More preferably, the deposited silicon nitride film 202 has a thickness of 70nm and a refractive index of 2.06. Furthermore, the gas for forming the silicon oxide film 203 located on the side of the silicon nitride film 202 far away from the silicon wafer 10 includes N₂O and SiH₄, where the gas flow rate of N₂O is 2000sccm, and the gas flow rate of SiH₄ is 200sccm. More preferably, the deposited silicon oxide film 203 has a thickness of 10nm and a refractive index of 1.5.

Step S4: printing an electrode on the silicon wafer after the anti-reflection film 20 is formed, and performing sintering on the silicon wafer after the electrode is printed, so as to manufacture the solar cell.

A solar cell is obtained by using the above-mentioned manufacturing method of the present invention.

In the method for manufacturing the solar cell provided by the embodiments of the invention, before the anti-reflection film is deposited on the surface of the silicon wafer, the silicon wafer is pre-processed, i.e., the plasma cleaning is performed on the silicon wafer by using an oxidizing gas, so as to form a compact first silicon oxide film on the surface of the silicon wafer while removing the impurity on the surface of the silicon wafer; then the anti-reflection film is formed on the surface of the silicon wafer after the plasma cleaning, i.e., the anti-reflection film is formed on the surface of the first silicon oxide film, where the anti-reflection film includes at least a silicon oxide film. Based on the good electrical insulation property of the silicon oxide film, the solar cell manufactured by using the method is insulated with the packaging material, the glass substrate and the glass backboard. Therefore, even in the case where some charges are accumulated on the surface of the solar cell, there is no leakage current between the solar cell and the grounding frame, so the photovoltaic module including the solar cell has an anti potential induced degradation effect, i.e., the potential induced degradation effect generated when the photovoltaic module operates under the high negative voltage for a long time can be reduced or eliminated, which improves the electrical performance of the photovoltaic module operating under the high negative voltage for a long time. Moreover, there is no need for a special packaging material, leading to a low cost. Furthermore, the technical solution is also compatible with the conventional manufacturing processes of the solar cell and thus suitable for large-scale production.

The various parts of the present invention are described in a progressive manner, with an emphasis placed on explaining the difference between each other. Hence, the same or similar content of one part may also be suitable for other parts.

The description of the embodiments herein enables those skilled in the art to implement or use the present invention. Multiple modifications to the embodiments will be apparent to those skilled in the art, and the general principle herein may be implemented in other embodiments without departing from the scope of the present invention as defined in the appended claims. Therefore, the present invention will not be limited to the embodiments described herein.

## Claims

1. A method for manufacturing a solar cell of reduced potential induced degradation, comprising:
performing plasma cleaning on a silicon wafer by using an oxidizing gas, so as to form a first silicon oxide film on the surface of the silicon wafer; and
forming an anti-reflection film on the surface of the first silicon oxide film, wherein the anti-reflection film comprises at least a silicon oxide film;
wherein the step of forming an anti-reflection film on the surface of the first silicon oxide film comprises:
depositing a uniform silicon nitride film on the surface of the first silicon oxide film, and depositing a uniform silicon oxide film on the surface of the silicon nitride film, so as to form the anti-reflection film.

2. The method for manufacturing the solar cell of reduced potential induced degradation according to claim 1, wherein the oxidizing gas comprises at least N₂O.

3. The method for manufacturing the solar cell of reduced potential induced degradation according to claim 2, wherein the plasma cleaning lasts for 30s to 900s, inclusive.

4. The method for manufacturing the solar cell of reduced potential induced degradation according to any one of claims 1 to 3, wherein the silicon oxide film in the anti-reflection film is deposited by using a method of PECVD, APCVD or LPCVD.

5. The method for manufacturing the solar cell of reduced potential induced degradation according to claim 4, wherein the silicon oxide film in the anti-reflection film is formed by gas comprising N₂O and SiH₄, and gas flow ratio of N₂O to SiH₄ ranges from 1 to 50:1, inclusive.

6. The method for manufacturing the solar cell of reduced potential induced degradation according to claim 5, wherein the silicon oxide film in the anti-reflection film has a thickness that ranges from 1nm to 150nm, inclusive.

7. The method for manufacturing the solar cell of reduced potential induced degradation according to claim 1, wherein the silicon nitride film in the anti-reflection film is deposited by using a method of PECVD, APCVD or LPCVD.

8. The method for manufacturing the solar cell of reduced potential induced degradation according to claim 7, wherein the silicon nitride film in the anti-reflection film is form by gas comprising NH₃ and SiH₄, and gas flow ratio of NH₃ to SiH₄ ranges from 1 to 30:1, inclusive.

9. The method for manufacturing the solar cell of reduced potential induced degradation according to claim 8, wherein the silicon nitride film in the anti-reflection film has a thickness that ranges from 10nm to 150nm, inclusive.

## Patentansprüche

1. Verfahren zur Herstellung einer Solarzelle mit reduziertem potentialinduzierten Leistungsverlust, umfassend:
Ausführen einer plasmabasierten Reinigung an einem Siliziumwafer unter Verwendung eines oxidierenden Gases, um eine erste Siliziumoxidschicht auf der Oberfläche des Siliziumwafers zu bilden; und
Bilden einer Antireflexionsschicht auf der Oberfläche der ersten Siliziumoxidschicht, wobei die Antireflexionsschicht zumindest eine Siliziumoxidschicht aufweist;
wobei der Schritt des Bildens der Antireflexionsschicht auf der Oberfläche der ersten Siliziumoxidschicht umfasst:
Abscheiden einer gleichmäßigen Siliziumnitridschicht auf der Oberfläche der ersten Siliziumoxidschicht, und Abscheiden einer gleichmäßigen Siliziumoxidschicht auf der Oberfläche der Siliziumnitridschicht, um die Antireflexionsschicht zu bilden.

2. Verfahren zur Herstellung einer Solarzelle mit reduziertem potentialinduzierten Leistungsverlust nach Anspruch 1, wobei das oxidierende Gas zumindest N₂O aufweist.

3. Verfahren zur Herstellung einer Solarzelle mit reduziertem potentialinduzierten Leistungsverlust nach Anspruch 2, wobei die plasmabasierte Reinigung zwischen 30s und einschließlich 900s lang dauert.

4. Verfahren zur Herstellung einer Solarzelle mit reduziertem potentialinduzierten Leistungsverlust nach einem der Ansprüche 1 bis 3, wobei die Siliziumoxidschicht in der Antireflexionsschicht abgeschieden wird, indem ein PECVD-, APCVD-oder LPCVD-Verfahren angewandt wird.

5. Verfahren zur Herstellung einer Solarzelle mit reduziertem potentialinduzierten Leistungsverlust nach Anspruch 4, wobei die Siliziumoxidschicht in der Antireflexionsschicht mittels eines Gases gebildet wird, das N₂O und SiH₄ umfasst, und das Gasstromverhältnis von N_{2O} zu SiH₄ im Bereich von 1:1 bis einschließlich 50:1 liegt.

6. Verfahren zur Herstellung einer Solarzelle mit reduziertem potentialinduzierten Leistungsverlust nach Anspruch 5, wobei die Siliziumoxidschicht in der Antireflexionsschicht eine Dicke hat, die im Bereich von 1nm bis einschließlich 150nm liegt.

7. Verfahren zur Herstellung einer Solarzelle mit reduziertem potentialinduzierten Leistungsverlust nach Anspruch 1, wobei die Siliziumnitridschicht in der Antireflexionsschicht abgeschieden wird, indem ein PECVD-, APCVD- oder LPCVD-Verfahren angewandt wird.

8. Verfahren zur Herstellung einer Solarzelle mit reduziertem potentialinduzierten Leistungsverlust nach Anspruch 7, wobei die Siliziumnitridschicht in der Antireflexionsschicht mittels eines Gases gebildet wird, das NH₃ und SiH₄ umfasst, und das Gasstromverhältnis von NH₃ zu SiH₄ im Bereich von 1:1 bis einschließlich 30:1 liegt.

9. Verfahren zur Herstellung einer Solarzelle mit reduziertem potentialinduzierten Leistungsverlust nach Anspruch 8, wobei die Siliziumnitridschicht in der Antireflexionsschicht eine Dicke hat, die im Bereich von 10nm bis einschließlich 150nm liegt.

## Revendications

1. Procédé de fabrication d'une cellule solaire à dégradation induite par potentiel réduite, comprenant :
l'exécution d'un nettoyage au plasma sur une tranche de silicium au moyen d'un gaz oxydant, de manière à former un premier film d'oxyde de silicium sur la surface de la tranche de silicium ; et
la formation d'un film anti-réflexion sur la surface du premier film d'oxyde de silicium, sachant que le film anti-réflexion comprend au moins un film d'oxyde de silicium ;
sachant que l'étape de formation d'un film anti-réflexion sur la surface du premier film d'oxyde de silicium comprend :
le dépôt d'un film de nitrure de silicium uniforme sur la surface du premier film d'oxyde de silicium, et le dépôt d'un film d'oxyde de silicium uniforme sur la surface du film de nitrure de silicium, de manière à former le film anti-réflexion.

2. Le procédé de fabrication de la cellule solaire à dégradation induite par potentiel réduite selon la revendication 1, sachant que le gaz oxydant comprend au moins du N₂O.

3. Le procédé de fabrication de la cellule solaire à dégradation induite par potentiel réduite selon la revendication 2, sachant que le nettoyage au plasma dure pendant 30 s à 900 s inclus.

4. Le procédé de fabrication de la cellule solaire à dégradation induite par potentiel réduite selon l'une des revendications 1 à 3, sachant que le film d'oxyde de silicium dans le film anti-réflexion est déposé au moyen d'un procédé de PECVD, APCVD ou LPCVD.

5. Le procédé de fabrication de la cellule solaire à dégradation induite par potentiel réduite selon la revendication 4, sachant que le film d'oxyde de silicium dans le film anti-réflexion est formé par du gaz comprenant du N₂O et du SiH₄, et un rapport de flux de gaz de N₂O à SiH₄ est compris entre 1 et 50:1 inclus.

6. Le procédé de fabrication de la cellule solaire à dégradation induite par potentiel réduite selon la revendication 5, sachant que le film d'oxyde de silicium dans le film anti-réflexion a une épaisseur comprise entre 1 nm et 150 nm inclus.

7. Le procédé de fabrication de la cellule solaire à dégradation induite par potentiel réduite selon la revendication 1, sachant que le film de nitrure de silicium dans le film anti-réflexion est déposé au moyen d'un procédé de PECVD, APCVD ou LPCVD.

8. Le procédé de fabrication de la cellule solaire à dégradation induite par potentiel réduite selon la revendication 7, sachant que le film de nitrure de silicium dans le film anti-réflexion est formé par du gaz comprenant du NH₃ et du SiH₄, et un rapport de flux de gaz de NH₃ à SiH₄ est compris entre 1 et 30:1 inclus.

9. Le procédé de fabrication de la cellule solaire à dégradation induite par potentiel réduite selon la revendication 8, sachant que le film de nitrure de silicium dans le film anti-réflexion a une épaisseur comprise entre 10 nm et 150 nm inclus.
